# EUROPEAN PATENT APPLICATION

(11) **EP 4 435 872 A1**
(43) Date of publication of application: **25.09.2024**
(21) Application number: 23213428.8
(22) Date of filing: 30.11.2023
(51) Int. Cl.: H01L 29/78, H01L 29/872

(54) **SEMICONDUCTOR DEVICE**

(30) Priority: 24.03.2023 JP 2023048268
(71) Applicant: Kabushiki Kaisha Toshiba, Minato-ku Tokyo (JP); Toshiba Electronic Devices & Storage Corporation, Tokyo (JP)
(72) Inventor: KONO, Hiroshi, Tokyo (JP)
(74) Representative: Kramer Barske Schmidtchen Patentanwälte PartG mbB

(57) **Abstract**

A semiconductor device includes a first electrode, a first semiconductor layer connected to the first electrode, a second semiconductor layer located on a portion of the first semiconductor layer, a third semiconductor layer located on a first portion of the second semiconductor layer, a fourth semiconductor layer located on a second portion of the second semiconductor layer, a fifth semiconductor layer located on a third portion of the second semiconductor layer, a second electrode, a third electrode connected to the third, fourth, and fifth semiconductor layers, and a metal film connected to the third electrode. A length in a second direction of the fifth semiconductor layer is greater than a length in the second direction of the fourth semiconductor layer. The second direction crosses a first direction. The first direction is from the first electrode toward the first semiconductor layer.

## Description

### FIELD

Embodiments relate to a semiconductor device.

### BACKGROUND

There are power control semiconductor devices that include silicon carbide (SiC). Silicon carbide has a higher dielectric breakdown electric field intensity than silicon (Si) and can be used to realize a high performance power control semiconductor device. When a system fault or the like occurs, it is necessary for a power control semiconductor device to withstand a surge current that is greater than the rated current for a short time span. In particular, it is common for a semiconductor device that includes silicon carbide to be used at a higher current density because silicon carbide can have a lower element resistance than silicon. It is therefore desirable for a semiconductor device that includes silicon carbide to withstand a high surge current.

### BRIEF DESCRIPTION OF THE DRAWINGS

FIG. 1A is a plan view showing a semiconductor device according to a first embodiment; and FIG. 1B is a plan view showing a semiconductor part of the semiconductor device according to the first embodiment;
FIG. 2 is a plan view showing a gate electrode structure and a surge trigger layer of the semiconductor device according to the first embodiment;
FIG. 3 is a cross-sectional view along line A-A' shown in FIG. 2;
FIG. 4 is a cross-sectional view along B-B' line shown in FIG. 1B;
FIGS. 5A and 5B are schematic cross-sectional views showing operations of the semiconductor device according to the first embodiment;
FIG. 6A is a plan view showing a semiconductor device according to a comparative example; and FIG. 6B is a cross-sectional view along line D-D' shown in FIG. 6A;
FIG. 7 is a plan view showing a semiconductor part of a semiconductor device according to a first modification of the first embodiment;
FIG. 8 is a plan view showing a semiconductor part of a semiconductor device according to a second modification of the first embodiment;
FIG. 9 is a plan view showing a semiconductor part of a semiconductor device according to a third modification of the first embodiment;
FIG. 10 is a plan view showing a semiconductor part of a semiconductor device according to a fourth modification of the first embodiment;
FIG. 11 is a plan view showing a semiconductor part of a semiconductor device according to a fifth modification of the first embodiment;
FIG. 12 is a cross-sectional view along E-E' line shown in FIG. 11;
FIG. 13A is a plan view showing a semiconductor device according to a second embodiment; and FIG. 13B is a plan view showing a semiconductor part of the semiconductor device according to the second embodiment; and
FIG. 14 is a cross-sectional view along F-F' line shown in FIG. 13A.

### DETAILED DESCRIPTION

A semiconductor device according to one embodiment, includes a first electrode, a first semiconductor layer connected to the first electrode, a second semiconductor layer located on a portion of the first semiconductor layer, a third semiconductor layer located on a first portion of the second semiconductor layer, a fourth semiconductor layer located on a second portion of the second semiconductor layer, a fifth semiconductor layer located on a third portion of the second semiconductor layer, a second electrode, a third electrode connected to the third, fourth, and fifth semiconductor layers, and a metal film connected to the third electrode. The first semiconductor layer includes silicon and carbon. The first semiconductor layer is of a first conductivity type. The second semiconductor layer contacts the first semiconductor layer and includes silicon and carbon. The second semiconductor layer is of a second conductivity type. The third semiconductor layer includes silicon and carbon. The third semiconductor layer is of the first conductivity type. The fourth semiconductor layer includes silicon and carbon. The fourth semiconductor layer is of the second conductivity type. The fourth semiconductor layer has a higher carrier concentration than the second semiconductor layer. The fifth semiconductor layer includes silicon and carbon. The fifth semiconductor layer is of the second conductivity type. The fifth semiconductor layer has a higher carrier concentration than the second semiconductor layer. A length in a second direction of the fifth semiconductor layer is greater than a length in the second direction of the fourth semiconductor layer. The second direction crosses a first direction. The first direction is from the first electrode toward the first semiconductor layer. The second electrode faces, via an insulating film, a portion of the second semiconductor layer located between the first semiconductor layer and the third semiconductor layer. The metal film is located in a region that includes a region directly above the fifth semiconductor layer and is on the third electrode.

A semiconductor device according to one embodiment, includes a first electrode, a first semiconductor layer connected to the first electrode, a second semiconductor layer located on a portion of the first semiconductor layer, a third semiconductor layer located on a portion of the second semiconductor layer, a metal layer located on the first semiconductor layer, a second electrode located on the metal layer and connected to the metal layer, and a metal film connected to the second electrode. The first semiconductor layer includes silicon and carbon. The first semiconductor layer is of a first conductivity type. The second semiconductor layer contacts the first semiconductor layer and includes silicon and carbon. The second semiconductor layer is of a second conductivity type. The third semiconductor layer contacts the second semiconductor layer and includes silicon and carbon. The third semiconductor layer is of the second conductivity type. The third semiconductor layer has a higher carrier concentration than the second semiconductor layer. The metal layer forms a Schottky junction with the first semiconductor layer. The metal film is located in a region that is on the second electrode and includes a region directly above the third semiconductor layer.

### First embodiment

A semiconductor device according to the embodiment is a vertical semiconductor device for power control and is, for example, a MOSFET (Metal-Oxide-Semiconductor Field-Effect Transistor).

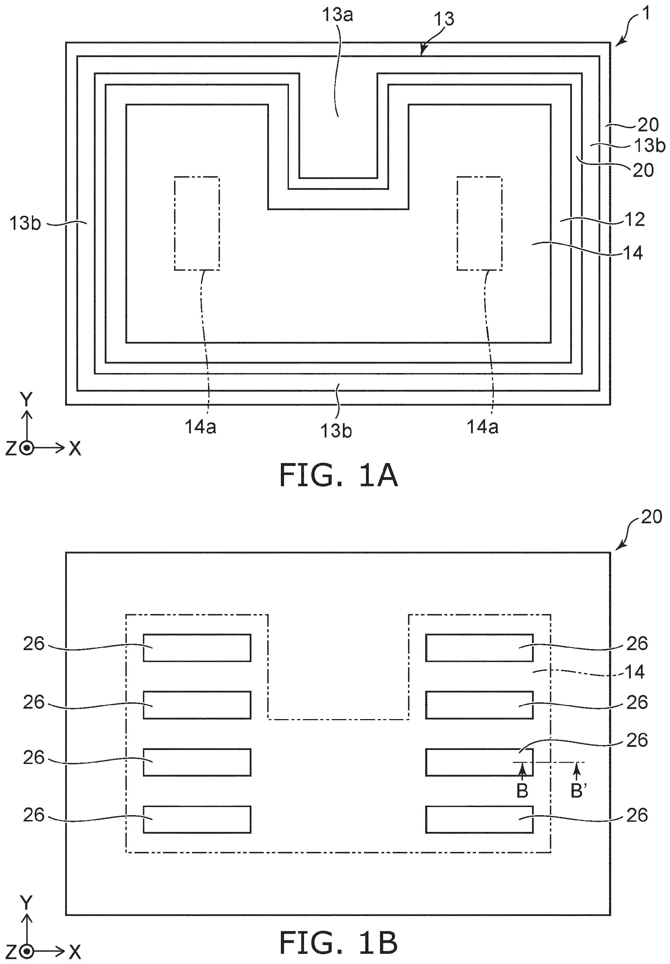

FIG. 1A is a plan view showing the semiconductor device according to the embodiment; and FIG. 1B is a plan view showing a semiconductor part of the semiconductor device according to the embodiment.

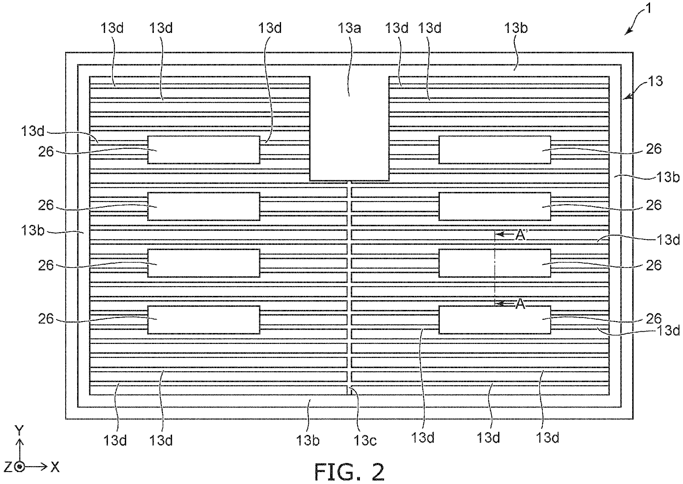

FIG. 2 is a plan view showing a gate electrode structure and a surge trigger layer of the semiconductor device according to the embodiment.

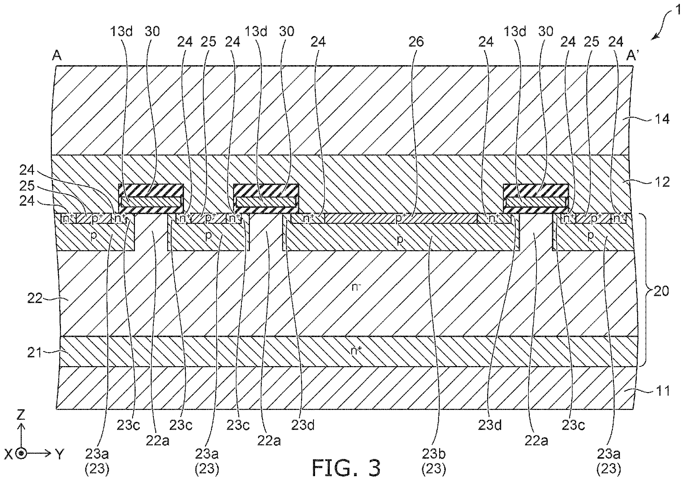

FIG. 3 is a cross-sectional view along line A-A' shown in FIG. 2.

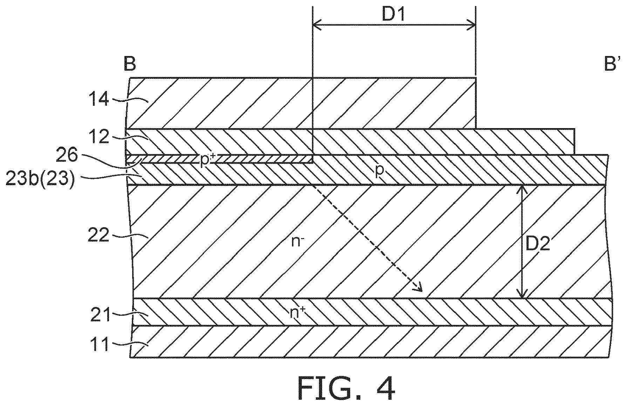

FIG. 4 is a cross-sectional view along B-B' line shown in FIG. 1B.

As shown in FIGS. 1A to 4, the semiconductor device 1 according to the embodiment includes a drain electrode 11 (a first electrode), the semiconductor part 20, a source electrode 12 (a third electrode), a gate electrode structure 13, an insulating film 30, and a metal film 14. For example, the semiconductor part 20 has a rectangular plate shape. For example, the drain electrode 11, the source electrode 12, and the metal film 14 are formed of metals.

An XYZ orthogonal coordinate system is employed for convenience of description in the specification hereinbelow. The direction from the drain electrode 11 toward the source electrode 12 is taken as a "Z-direction" (a first direction); and two directions in which the outer edges of the semiconductor device 1 extend when viewed along the Z-direction are taken as a "Y-direction" (a second direction) and an "X-direction" (a third direction). The forward direction of each direction may be marked with "+", and the opposite direction may be marked with "-" as necessary. The Z-direction (the +Z direction) also is called "up", and the opposite direction (the -Z direction) also is called "down", but these expressions are for convenience and are independent of the direction of gravity.

The drain electrode 11 is provided over the entire surface of the lower surface of the semiconductor part 20. The gate electrode structure 13 includes a gate pad 13a, a gate perimeter wiring part 13b, a gate trunk wiring part 13c, and a gate electrode 13d (a second electrode).

An example of the gate electrode structure 13 will now be described. The gate pad 13a is located on the upper surface of the semiconductor part 20 at the X-direction central portion of the end portion at the +Y direction side. The gate perimeter wiring part 13b is drawn out to the two X-direction sides from the end portion of the gate pad 13a at the +Y direction side and extends around the outer edges of the semiconductor device 1. The gate pad 13a and the gate perimeter wiring part 13b are made of an electrically-conductive material and are formed of, for example, a metal.

The gate trunk wiring part 13c extends in the Y-direction; and the two end portions of the gate trunk wiring part 13c are connected respectively to the end portion of the gate pad 13a at the -Y direction side and the portion of the gate perimeter wiring part 13b extending along the end portion of the semiconductor part 20 at the -Y direction side. In the specification, "connected" means an electrical connection. Multiple gate electrodes 13d are provided, and each gate electrode 13d extends in the X-direction. The two end portions of each gate electrode 13d are connected respectively to the gate pad 13a and the gate perimeter wiring part 13b or connected respectively to the gate trunk wiring part 13c and the gate perimeter wiring part 13b. The gate trunk wiring part 13c and the gate electrode 13d are made of an electrically-conductive material and are formed of, for example, electrically-conductive polysilicon that includes an impurity.

The source electrode 12 is located in a region on the upper surface of the semiconductor part 20 that is separated from the gate pad 13a and the gate perimeter wiring part 13b. Therefore, the shape of the source electrode 12 is a U-shape that is surrounded with the gate perimeter wiring part 13b and surrounds the gate pad 13a from three directions when viewed along the Z-direction.

The gate trunk wiring part 13c and the gate electrode 13d are located between the semiconductor part 20 and the source electrode 12. The insulating film 30 is located between the semiconductor part 20 and the gate pad 13a, between the semiconductor part 20 and the gate perimeter wiring part 13b, and at a position so that the insulating film 30 surrounds the gate trunk wiring part 13c and the gate electrode 13d. The insulating film 30 is made of an insulating material and is formed of, for example, silicon dioxide (SiO₂). The gate electrode structure 13 is thereby insulated from the semiconductor part 20 and the source electrode 12 by the insulating film 30.

As shown in FIG. 3, the semiconductor part 20 is made of a semiconductor material that includes silicon (Si) and carbon (C) and is made of, for example, single-crystal silicon carbide (SiC). The conductivity types of the portions of the semiconductor part 20 each are set to a p-type or an n-type by introducing impurities. The semiconductor part 20 includes a drain layer 21, a drift layer 22, a base layer 23 (the second semiconductor layer), a source layer 24 (the third semiconductor layer), a base contact layer 25 (a fourth semiconductor layer), and a surge trigger layer 26 (a fifth semiconductor layer).

Hereinbelow, the notations of "n⁺-type", "n-type", and "n⁻ -type" of the conductivity types indicate the relative magnitude relationship of the carrier concentrations; the "n⁺-type" indicates a higher carrier concentration than the "n-type"; and the "n⁻-type" indicates a lower carrier concentration than the "n-type". Similarly for the p-type, the "p⁺-type" indicates a higher carrier concentration than the "p-type". The "carrier concentration" means the effective impurity concentration contributing to the electrical conductivity of the semiconductor material, and corresponds to the net impurity concentration excluding the cancelled portion when one region includes both an impurity that forms donors and an impurity that forms acceptors.

The conductivity type of the drain layer 21 is the n⁺-type. The carrier concentration of the drain layer 21 is, for example, about 5×10¹⁹ cm⁻³. The drain layer 21 forms the lower surface of the semiconductor part 20. The drain layer 21 is located on the drain electrode 11. The drain layer 21 contacts the drain electrode 11 and is therefore connected to the drain electrode 11.

The conductivity type of the drift layer 22 is the n⁻-type. The drift layer 22 is located on the drain layer 21 and contacts the drain layer 21. The carrier concentration of the drift layer 22 is less than the carrier concentration of the drain layer 21. The carrier concentration of the drift layer 22 is, for example, not less than 1×10¹⁵ cm⁻³ and not more than 5×10¹⁶ cm⁻³. The carrier concentration at the boundary between the drain layer 21 and the drift layer 22 is, for example, 5×10¹⁷ cm⁻³. A first semiconductor layer includes the drain layer 21 and the drift layer 22.

The conductivity type of the base layer 23 is the p-type. The base layer 23 is located on a portion of the drift layer 22 and contacts the drift layer 22. Accordingly, the interface between the p-type base layer 23 and the n⁻-type drift layer 22 forms a p-n junction. The base layer 23 is divided into multiple parts 23a and multiple parts 23b. The parts 23a and 23b extend in the same direction as the gate electrode 13d, i.e., the X-direction, and are separated from each other along the Y-direction. For example, one part 23b is provided for every several or every tens of parts 23a. The length of the part 23b in the Y-direction is greater than the length of the part 23a in the Y-direction. A portion 22a of the drift layer 22 is interposed between the adjacent parts 23a and between the part 23a and the part 23b.

The conductivity type of the source layer 24 is the n⁺-type. Accordingly, the interface between the p-type base layer 23 and the n⁺-type source layer 24 forms a p-n junction. The carrier concentration of the source layer 24 is greater than the carrier concentration of the drift layer 22. The source layer 24 contacts the base layer 23 and is located on a portion (a first portion) of each part 23a of the base layer 23 and on a portion (the first portion) of each part 23b of the base layer 23. On the other hand, the source layer 24 is separated from the drift layer 22. Each source layer 24 extends in the X-direction.

The conductivity type of the base contact layer 25 is the p⁺-type. The carrier concentration of the base contact layer 25 is greater than the carrier concentration of the base layer 23. In other words, the effective acceptor concentration of the base contact layer 25 is greater than the effective acceptor concentration of the base layer 23. The base contact layer 25 is located on each part 23a of the base layer 23 on a portion (a second portion) at which the source layer 24 is not provided. The base contact layer 25 contacts the part 23a of the base layer 23. The base contact layer 25 may contact the source layer 24. Each base contact layer 25 extends in the X-direction.

The conductivity type of the surge trigger layer 26 is the p⁺-type. The carrier concentration of the surge trigger layer 26 is greater than the carrier concentration of the base layer 23. In other words, the effective acceptor concentration of the surge trigger layer 26 is greater than the effective acceptor concentration of the base layer 23. The surge trigger layer 26 is located on each part 23b of the base layer 23 on a portion (a third portion) at which the source layer 24 is not provided. The surge trigger layer 26 contacts the part 23b of the base layer 23. The surge trigger layer 26 may contact the source layer 24.

Thus, the source layer 24 is located on both the parts 23a and 23b of the base layer 23; the base contact layer 25 is located only on the part 23a; and the surge trigger layer 26 is located only on the part 23b.

As shown in FIG. 2, multiple surge trigger layers 26 are arranged in a matrix configuration along the X-direction and the Y-direction. According to the embodiment, for example, eight surge trigger layers 26 are arranged in four rows along the Y-direction and two columns along the X-direction. The X-direction length is greater than the Y-direction length for each surge trigger layer 26.

In the part 23a of the base layer 23 as shown in FIG. 3, the source layers 24 are located at positions separated from the edges of the part 23a at the two Y-direction sides; and the base contact layer 25 is located between the two source layers 24. The portion of the part 23a located between the source layer 24 and the portion 22a of the drift layer 22 is called a "channel portion 23c".

In the part 23b of the base layer 23 as well, the source layers 24 are located at positions separated from the edges of the part 23b at the two Y-direction sides. The surge trigger layer 26 is located between the two source layers 24. The portion of the part 23b located between the source layer 24 and the portion 22a of the drift layer 22 is called a "channel portion 23d".

The upper surface of the semiconductor part 20 is formed by the portion 22a of the drift layer 22, the channel portions 23c and 23d of the base layer 23, the source layer 24, the base contact layer 25, and the surge trigger layer 26.

The gate electrode 13d is located on the semiconductor part 20 in the region directly above the portion 22a of the drift layer 22, in the region directly above the portion of the source layer 24 at the portion 22a side, and in the regions directly above the channel portions 23c and 23d of the base layer 23. The gate electrode 13d faces the channel portions 23c and 23d via portions of the insulating film 30.

The source electrode 12 is located on the semiconductor part 20 and covers the insulating film 30. The source electrode 12 is connected to the source layer 24, the base contact layer 25, and the surge trigger layer 26. A silicide layer (not illustrated) may be formed in at least a portion of the region of the upper surface of the semiconductor part 20 contacting the source electrode 12. The silicide layer is made of, for example, nickel silicide.

As shown in FIGS. 1B and 3, the metal film 14 is located in a region on the source electrode 12 that includes the region directly above the surge trigger layer 26. In other words, the surge trigger layer 26 is located inside the metal film 14 when viewed along the Z-direction. The metal film 14 is connected to the source electrode 12. It is favorable for the metal film 14 to be made of a metal having high electrical conductivity and thermal conductivity, and is made of, for example, copper (Cu). The metal film 14 may be formed of nickel (Ni). It is favorable for the metal film 14 to be thicker than the source electrode 12.

The metal film 14 is located inside the source electrode 12 when viewed along the Z-direction. Discrepancies due to the metal film 14 contacting the gate pad 13a or the gate perimeter wiring part 13b of the gate electrode structure 13 or the metal film 14 reaching the edge of the semiconductor device 1 can be avoided thereby. An external terminal bonding region 14a to which an external terminal such as a bonding wire, a connector, or the like is bonded is set in the upper surface of the metal film 14.

As shown in FIG. 4, a shortest distance D1 between the outer edge of the surge trigger layer 26 and the outer edge of the metal film 14 when viewed along the Z-direction is not less than a shortest distance D2 between the drain layer 21 and the base layer 23 in the Z-direction. In other words, *D1* ≥ *D2.* The distance D2 corresponds to the thickness of the portion of the drift layer 22 other than the portion 22a.

Operations of the embodiment will now be described.

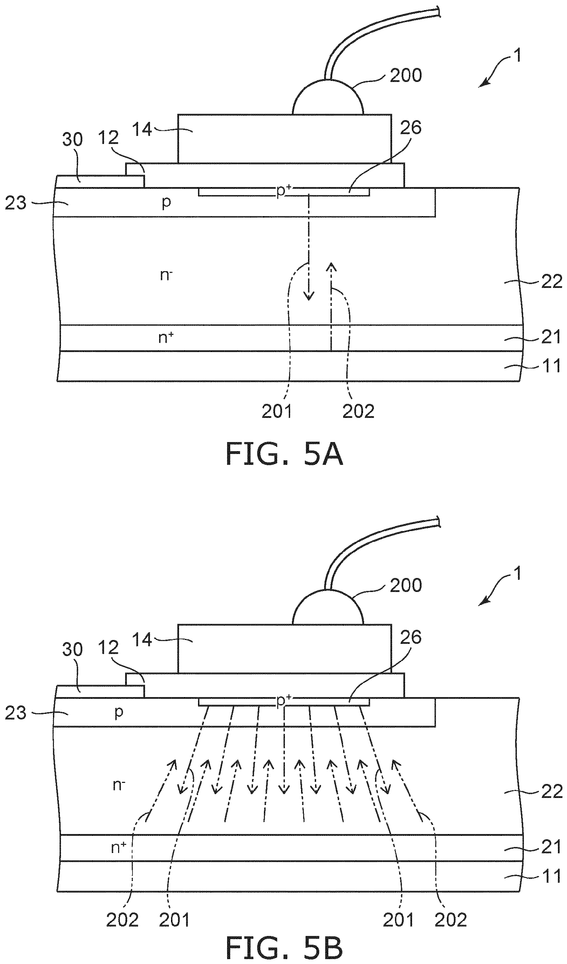

FIGS. 5A and 5B are schematic cross-sectional views showing operations of the semiconductor device according to the embodiment.

As shown in FIGS. 1A and 3, external terminals 200 (see FIG. 5A) are connected to the drain electrode 11, the external terminal bonding region 14a of the metal film 14 and the gate pad 13a of the gate electrode structure 13 of the semiconductor device 1.

First, normal operations of the semiconductor device 1 will be described.

A voltage is applied between the drain electrode 11 and the source electrode 12 so that the drain electrode 11 is positive and the source electrode 12 is negative. As a result, a depletion layer (not illustrated) spreads with the interface between the drift layer 22 and the base layer 23 as a starting point.

When a potential that is not less than a threshold is applied to the gate electrode 13d in this state, an inversion layer (not illustrated) is formed in the channel portions 23c and 23d of the base layer 23; a current flows from the drain electrode 11 toward the source electrode 12; and the semiconductor device 1 is set to the on-state. On the other hand, when a potential that is less than the threshold is applied to the gate electrode 13d, the inversion layer disappears, and the semiconductor device 1 is switched to the off-state.

An operation of allowing a reverse surge current to flow will now be described.

As shown in FIG. 5A, when the semiconductor device 1 is in the off-state, there are cases where a large reverse current flows from the source electrode 12 toward the drain electrode 11 due to an external factor such as a system fault, etc. In such a case, it is common for the surge current to start to flow from the region directly under the metal film 14 to which the surge voltage is easily conducted, and particularly from the region directly under the external terminal bonding region 14a to which the external terminal 200 is bonded.

At this time, a hole current 201 is introduced to the semiconductor part 20 from the source electrode 12 via the surge trigger layer 26 in the region directly under the external terminal 200. Then, the hole current 201 induces an electron current 202 that is introduced to the semiconductor part 20 via the drain electrode 11 and the drain layer 21. The surge current includes the hole current 201 and the electron current 202.

Then, as shown in FIG. 5B, the holes and electrons that are generated in the semiconductor part 20 and are in the plasma state spread along the surge trigger layer 26, thereby increasing the region in which the hole current 201 and the electron current 202 flow and causing more current to flow. Thus, the region of the semiconductor device 1 in which the hole current 201 and the electron current 202 flows is restricted by the surge trigger layer 26. When the flow of the applied surge current is exhausted, the hole current 201 and the electron current 202 stop, and the state returns to the original state.

Effects of the embodiment will now be described.

In the semiconductor device 1 according to the embodiment as described above, the region in which the surge current flows is substantially limited to the region in which the surge trigger layer 26 is located. The surge trigger layer 26 is located in the region directly under the metal film 14. Therefore, the surge current flows mainly in the region directly under the metal film 14; and the flow of the surge current outside the region directly under the metal film 14 can be suppressed. As a result, the concentration of the surge current at the end portion of the metal film 14 and the region directly under the source electrode 12 can be suppressed. Therefore, the semiconductor device 1 can be more resistant to the surge current. In particular, the semiconductor device 1 can be more resistant to the surge current by suppressing the current concentration in the end portion of the source electrode 12.

According to the embodiment as shown in FIG. 4, the shortest distance D1 between the outer edge of the surge trigger layer 26 and the outer edge of the metal film 14 when viewed along the Z-direction is not less than the shortest distance D2 between the drain layer 21 and the base layer 23 in the Z-direction. Accordingly, the electron current 202 that is induced by the hole current 201 passing through the surge trigger layer 26 and the base layer 23 and flowing through the drift layer 22 at an angle tilted 45 degrees with respect to the Z-direction also is introduced from the region directly under the metal film 14; and the concentration of the surge current in the end portion of the metal film 14 and the region directly under the source electrode 12 can be more effectively suppressed.

The heat dissipation is good because the metal film 14 is located in the region of the semiconductor part 20 directly above the region in which the surge current flows. Damage due to overheating of the semiconductor part 20 also can be suppressed thereby.

### Comparative example

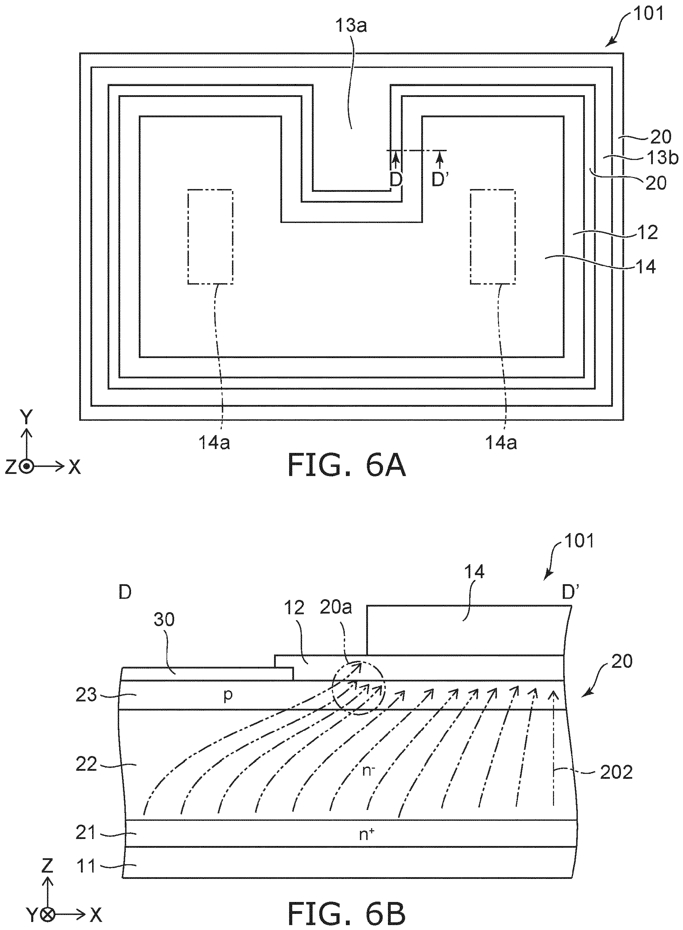

FIG. 6A is a plan view showing a semiconductor device according to a comparative example; and FIG. 6B is a cross-sectional view along line D-D' shown in FIG. 6A.

As shown in FIGS. 6A and 6B, the surge trigger layer 26 is not included in the semiconductor device 101 according to the comparative example.

When a surge voltage is applied to the semiconductor device 101, the likelihood is high that the starting point of the surge current from which the surge current starts to flow will be in the region directly under the metal film 14, and particularly in the region directly under the external terminal 200; however, as the holes and electrons that are introduced to the semiconductor part 20 and are in the plasma state diffuse along the XY plane, and as the voltage applied to the drift layer 22 and the base layer 23 increases, the surge current also starts to flow in regions outside the region directly under the metal film 14.

As a result, the surge current may flow in the semiconductor part 20 in both the region directly under the metal film 14 and in other regions. On the other hand, the electron current 202 concentrates at the external terminal 200 via the metal film 14. The hole current 201 diffuses in the semiconductor part 20 from the metal film 14. As a result, the surge current from portions of the semiconductor part 20 other than the region directly under the metal film 14 concentrate in the end portion of the metal film 14. Accordingly, the current also concentrates in a portion 20a of the semiconductor part 20 at the vicinity of the end portion of the metal film 14; and this portion 20a is easily damaged. Also, overheating easily occurs when the surge current flows in portions of the semiconductor part 20 other than the region directly under the metal film 14 because the heat dissipation effect of the metal film 14 is low. Therefore, breakdown of the semiconductor device 101 easily occurs at the vicinity of the end portion of the metal film 14.

### First modification of first embodiment

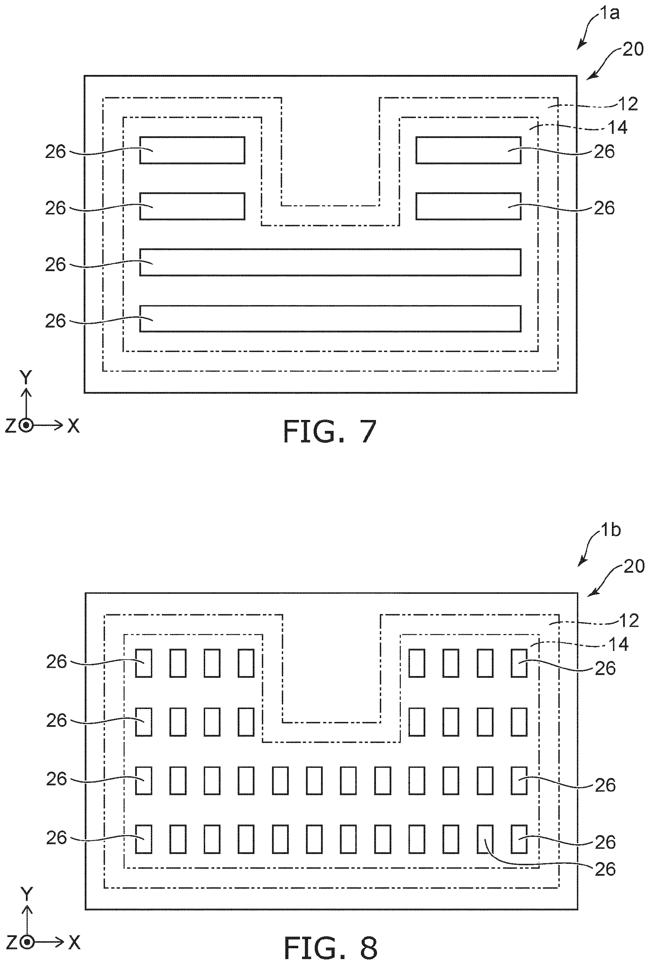

FIG. 7 is a plan view showing a semiconductor part of a semiconductor device according to the modification.

As shown in FIG. 7, the arrangement of the surge trigger layer 26 in the semiconductor device 1a according to the modification is different from that of the semiconductor device 1 according to the first embodiment.

According to the modification, similarly to the first embodiment, multiple surge trigger layers 26 are located in the region directly under the metal film 14. Specifically, two surge trigger layers 26 are located at each of the two X-direction sides of the gate pad 13a. Also, two surge trigger layers 26 are provided over substantially the entire X-direction length of the metal film 14 at the -Y direction side of the gate pad 13a. The X-direction lengths of these two surge trigger layers 26 are greater than the X-direction lengths of the surge trigger layers 26 located at the two X-direction sides of the gate pad 13a. Thus, a total of six surge trigger layers 26 are provided in the modification.

According to the modification, the region in which the surge current flows can be more widely diffused because the X-direction lengths of some of the surge trigger layers 26 are long. Breakdown of the semiconductor device 1a due to the concentration of the surge current at one location can be more effectively suppressed thereby. Otherwise, the configuration, operations, and effects according to the modification are similar to those of the first embodiment.

### Second modification of first embodiment

FIG. 8 is a plan view showing a semiconductor part of a semiconductor device according to the modification.

As shown in FIG. 8, the arrangement of the surge trigger layer 26 in the semiconductor device 1b according to the modification is different from that of the semiconductor device 1 according to the first embodiment.

According to the modification, multiple surge trigger layers 26 are arranged in a matrix configuration along the X-direction and the Y-direction. The X-direction length is less than the Y-direction length for each surge trigger layer 26. According to the modification, the area in which the surge current flows spreads from one surge trigger layer 26 to the adjacent surge trigger layers 26 via regions in which the surge trigger layer 26 is not provided. According to the modification, the area in which the surge current flows can be isotropically enlarged along the XY plane; and the concentration of the surge current can be more effectively suppressed. Otherwise, the configuration, operations, and effects according to the modification are similar to those of the first embodiment.

### Third modification of first embodiment

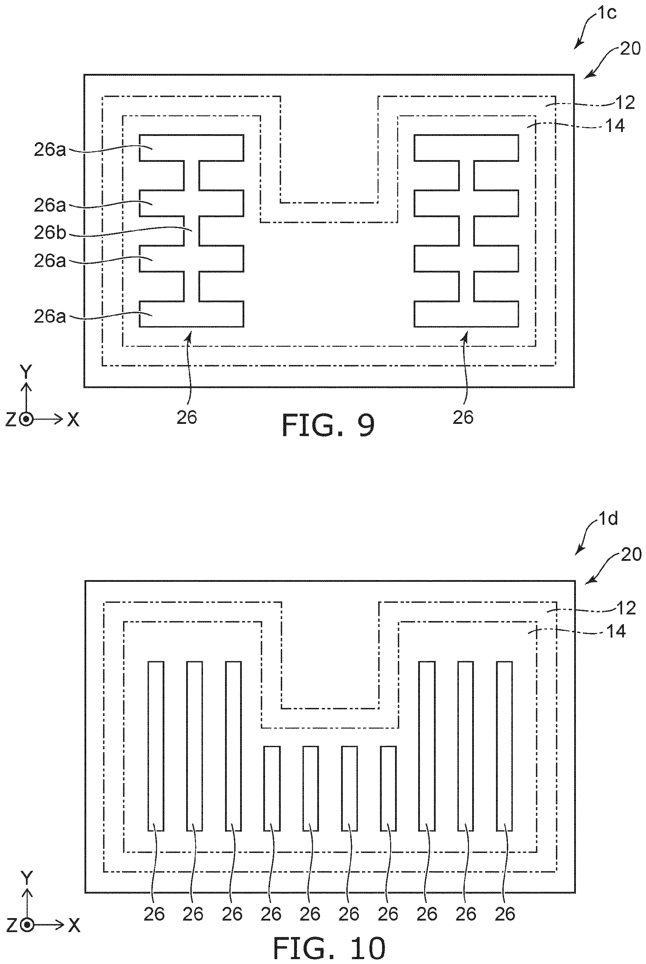

FIG. 9 is a plan view showing a semiconductor part of a semiconductor device according to the modification.

As shown in FIG. 9, the arrangement of the surge trigger layer 26 in the semiconductor device 1c according to the modification is different from that of the semiconductor device 1 according to the first embodiment.

According to the modification, one surge trigger layer 26 is located at each of the two X-direction sides of the gate pad 13a and the gate trunk wiring part 13c of the gate electrode structure 13. Four portions 26a that extend in the X-direction and one portion 26b that extends in the Y-direction are included in each surge trigger layer 26. The portion 26b that extends in the Y-direction contacts the four portions 26a that extend in the X-direction. According to the modification, compared with the second modification, the area in which the surge current flows can be isotropically enlarged along the XY plane while suppressing the area of the surge trigger layer 26 and ensuring the area of the active area that functions as the MOSFET. Otherwise, the configuration, operations, and effects according to the modification are similar to those of the first embodiment.

### Fourth modification of first embodiment

FIG. 10 is a plan view showing a semiconductor part of a semiconductor device according to the modification.

As shown in FIG. 10, the arrangement of the surge trigger layer 26 in the semiconductor device 1d according to the modification is different from that of the semiconductor device 1 according to the first embodiment.

According to the modification, multiple surge trigger layers 26 are arranged along the X-direction; and each surge trigger layer 26 extends along the Y-direction. In other words, the Y-direction length is greater than the X-direction length for each surge trigger layer 26. Also, the Y-direction lengths of the surge trigger layers 26 located at the -Y direction side of the gate pad 13a are less than the Y-direction lengths of the other surge trigger layers 26. According to the modification, the area in which the surge current flows can be preferentially enlarged along the Y-direction. There are cases where the modification is advantageous according to the characteristics necessary for the semiconductor device 1d. Otherwise, the configuration, operations, and effects according to the modification are similar to those of the first embodiment.

### Fifth modification of first embodiment

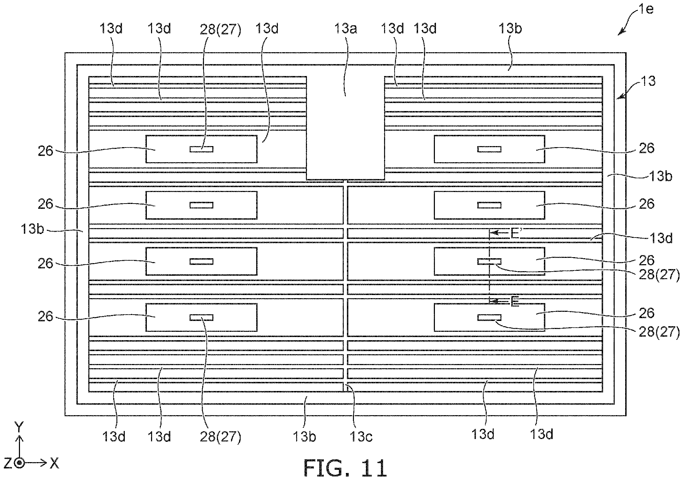

FIG. 11 is a plan view showing a semiconductor part of a semiconductor device according to the modification.

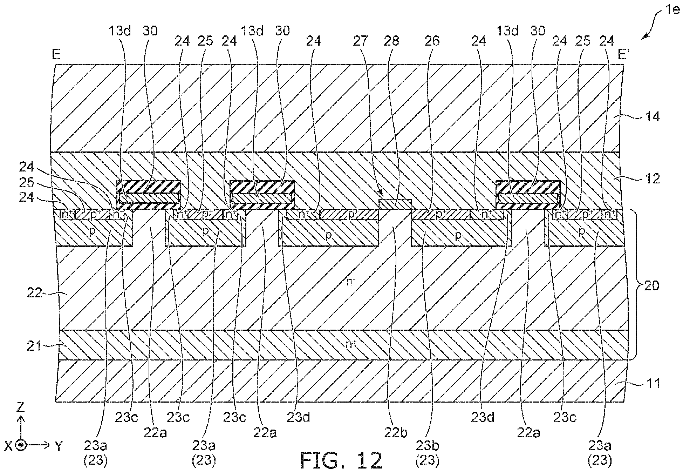

FIG. 12 is a cross-sectional view along E-E' line shown in FIG. 11.

As shown in FIGS. 11 and 12, the semiconductor device 1e according to the modification differs from the semiconductor device 1 according to the first embodiment in that a SBD (Schottky Barrier Diode) region 27 is located inside the surge trigger layer 26 when viewed from above, and the gate electrode 13d is not provided at the two X-direction sides of the surge trigger layer 26.

In the semiconductor device 1e according to the modification, a portion 22b of the n⁻-type drift layer 22 is located inside the surge trigger layer 26; and a metal layer 28 is located on the portion 22b. Similarly to the portion 22a, the portion 22b is a portion of the drift layer 22 above which the base layer 23 is not provided. The metal layer 28 is located between the portion 22b and the source electrode 12, contacts the portion 22b, and is connected to the source electrode 12. The metal layer 28 is made of a material that forms a Schottky junction with the portion 22b of the drift layer 22 and is formed of, for example, titanium (Ti), vanadium (V), molybdenum (Mo), nickel (Ni), or a compound of these elements. The SBD region 27 includes the portion 22b of the drift layer 22 and the metal layer 28.

According to the modification, by providing the SBD region 27, the voltage that is applied to the p-n junction in the low current region can be reduced. The bipolar operation in the rated current operation can be suppressed thereby, and the surge trigger region can be adjusted to operate only in the current range in which the surge current flows. Although an example is shown in the modification in which the SBD region 27 is located inside the surge trigger layer 26 when viewed from above, the position of the SBD region 27 is not limited thereto. For example, the SBD region 27 may be provided in the MOSFET region in addition to the surge trigger layer 26. Otherwise, the configuration, operations, and effects according to the modification are similar to those of the first embodiment.

### Second embodiment

A semiconductor device according to the embodiment is a vertical semiconductor device for power control and is, for example, a JBS (Junction Barrier Controlled Schottky) diode.

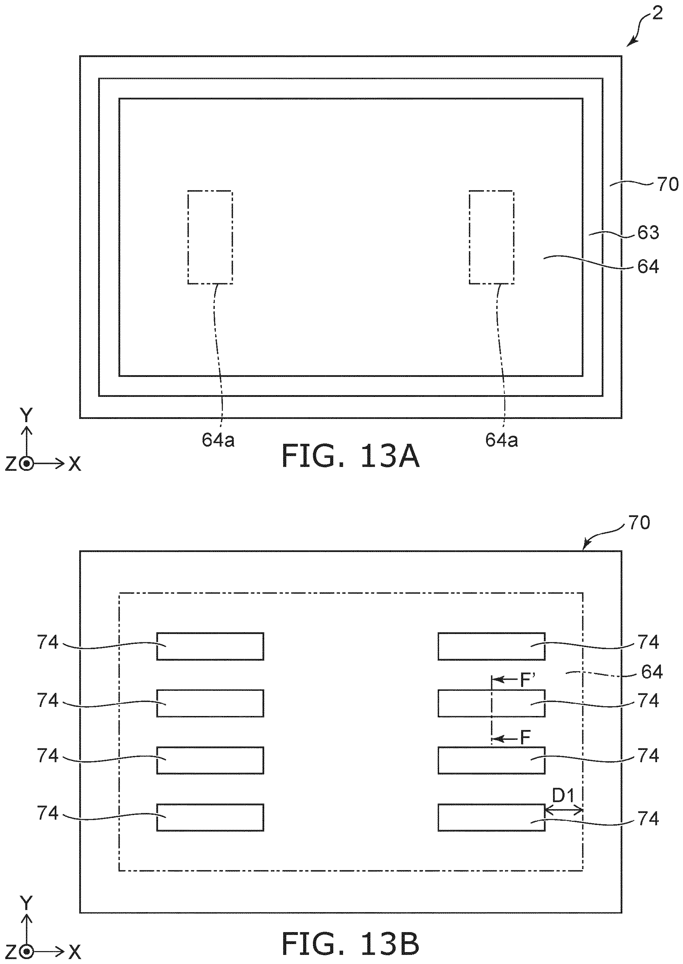

FIG. 13A is a plan view showing the semiconductor device according to the embodiment; and FIG. 13B is a plan view showing a semiconductor part of the semiconductor device according to the embodiment.

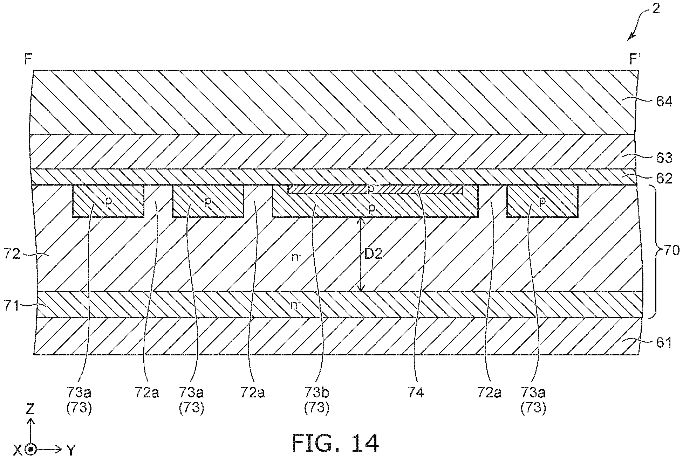

FIG. 14 is a cross-sectional view along F-F' line shown in FIG. 13A.

As shown in FIGS. 13A to 14, the semiconductor device 2 according to the embodiment includes a cathode electrode 61 (the first electrode), a semiconductor part 70, a metal layer 62, an anode electrode 63 (the second electrode), and a metal film 64. For example, the semiconductor part 70 has a rectangular plate shape.

The semiconductor part 70 is made of a semiconductor material that includes silicon (Si) and carbon (C) and is made of, for example, single-crystal silicon carbide (SiC). The conductivity types of the portions of the semiconductor part 70 are set to the p-type or the n-type by introducing impurities to the portions. The semiconductor part 70 includes a cathode layer 71, a drift layer 72, an anode layer 73 (the second semiconductor layer), and a surge trigger layer 74 (the third semiconductor layer).

The conductivity type of the cathode layer 71 is the n⁺-type. The carrier concentration of the cathode layer 71 is, for example, about 5×10¹⁹ cm⁻³. The cathode layer 71 forms the lower surface of the semiconductor part 70. The cathode layer 71 is located on the cathode electrode 61, contacts the cathode electrode 61, and is thereby connected to the cathode electrode 61. The cathode electrode 61 is provided over the entire surface of the lower surface of the semiconductor part 70.

The conductivity type of the drift layer 72 is the n⁻-type. The drift layer 72 is located on the cathode layer 71 and contacts the cathode layer 71. The carrier concentration of the drift layer 72 is less than the carrier concentration of the cathode layer 71. The carrier concentration of the drift layer 72 is, for example, not less than 1×10¹⁵ cm⁻³ and not more than 5×10¹⁶ cm⁻³. The carrier concentration at the boundary between the cathode layer 71 and the drift layer 72 is, for example, 5×10¹⁷ cm⁻³. The first semiconductor layer includes the cathode layer 71 and the drift layer 72.

The conductivity type of the anode layer 73 is the p-type. The anode layer 73 is located on a portion of the drift layer 72 and contacts the drift layer 72. Accordingly, the interface between the p-type anode layer 73 and the n⁻-type drift layer 72 forms a p-n junction. The anode layer 73 is divided into multiple parts 73a and multiple parts 73b. The parts 73a and 73b extend in the X-direction and are arranged to be separated from each other along the Y-direction. For example, one part 73b is provided for every several to tens of parts 73a. The length of the part 73b in the Y-direction is greater than the length of the part 73a in the Y-direction. Portions 72a of the drift layer 72 are interposed between the adjacent parts 73a and between the part 73a and the part 73b.

The conductivity type of the surge trigger layer 74 is the p⁺-type. The carrier concentration of the surge trigger layer 74 is greater than the carrier concentration of the anode layer 73. The surge trigger layer 74 is located on each part 73b of the anode layer 73 in a region that is separated from the portion 72a of the drift layer 72. The surge trigger layer 74 contacts the part 73b of the anode layer 73. The surge trigger layer 74 is not provided on the part 73a of the anode layer 73.

Multiple surge trigger layers 74 are arranged in a matrix configuration along the X-direction and the Y-direction. According to the embodiment as shown in FIG. 11B, for example, eight surge trigger layers 74 are arranged in four rows along the Y-direction and two columns along the X-direction. Each surge trigger layer 74 extends in the X-direction.

The upper surface of the semiconductor part 70 is formed of the surge trigger layer 74 and the portions at which the surge trigger layer 74 is not provided, including the portion 72a of the drift layer 72, the part 73a of the anode layer 73, and the part 73b of the anode layer 73.

The metal layer 62 is provided over the entire surface of the upper surface of the semiconductor part 70 and contacts the upper surface of the semiconductor part 70. Therefore, the metal layer 62 contacts the portion 72a of the drift layer 72, the anode layer 73, and the surge trigger layer 74. The metal layer 62 forms a Schottky junction with the drift layer 72. For example, the metal layer 62 is formed of titanium, vanadium, molybdenum, nickel, or a compound of these elements.

The anode electrode 63 is provided on substantially the entire upper surface of the metal layer 62 and is connected to the metal layer 62. The metal film 64 is connected to the anode electrode 63. The metal film 64 is located in the region of the upper surface of the anode electrode 63 other than the end portions, and is located in the region that includes the region directly above the surge trigger layer 74. In other words, the surge trigger layer 74 is located inside the metal film 64 when viewed along the Z-direction. The metal film 64 is made of a metal material and is made of copper or nickel. It is favorable for the metal film 64 to be thicker than the anode electrode 63.

The metal film 64 is located inside the anode electrode 63 when viewed along the Z-direction. Discrepancies in which the metal film 64 reaches the edge of the semiconductor device 2 can be avoided thereby. An external terminal bonding region 64a to which an external terminal such as a bonding wire, a connector, or the like is bonded is set in the upper surface of the metal film 64.

As described in reference to FIG. 4 according to the first embodiment, the shortest distance D1 between the outer edge of the surge trigger layer 74 and the outer edge of the metal film 64 when viewed along the Z-direction is not less than the shortest distance D2 between the cathode layer 71 and the anode layer 73 in the Z-direction. The distance D2 corresponds to the thickness of the portion of the drift layer 72 other than the portion 72a.

Operations of the embodiment will now be described.

First, normal operations of the semiconductor device 2 will be described.

When a voltage is applied between the anode electrode 63 and the cathode electrode 61 so that the anode electrode 63 is negative and the cathode electrode 61 is positive, a reverse voltage is applied to the Schottky barrier diode made of the metal layer 62 and the drift layer 72. Also, a depletion layer is formed between the anode layer 73 and the drift layer 72. Therefore, a current does not flow in the semiconductor device 2.

On the other hand, when a voltage is applied between the anode electrode 63 and the cathode electrode 61 so that the anode electrode 63 is positive and the cathode electrode 61 is negative, a forward voltage is applied to the Schottky barrier diode made of the metal layer 62 and the drift layer 72; and a current flows. When the forward voltage increases, a forward current flows in the p-n junction between the anode layer 73 and the drift layer 72.

An operation of allowing a forward surge current to flow will now be described.

A surge current flows in the semiconductor device 2 when a forward surge voltage is applied to the semiconductor device 2 by an external factor such as a system fault, etc. It is common for the surge current to start to flow from the region directly under the metal film 64, and particularly the region directly under the external terminal bonding region 64a to which the external terminal 200 (see FIG. 5A) is bonded.

At this time, in the region directly under the external terminal, the hole current is introduced to the semiconductor part 70 via the metal film 64, the anode electrode 63, the metal layer 62, and the surge trigger layer 74. Then, the hole current induces an electron current that is introduced to the semiconductor part 70 from the cathode electrode 61 via the cathode layer 71.

Then, the holes and electrons that are generated in the semiconductor part 70 and are in a plasma state spread along the surge trigger layer 74, thereby increasing the region in which the hole current and the electron current flow and causing more current to flow. Then, when the flow of the applied surge current is exhausted, the state returns to the original state.

Effects of the embodiment will now be described.

In the semiconductor device 2 according to the embodiment, similarly to the semiconductor device 1 according to the first embodiment, the region in which the surge current flows is limited to the region in which the surge trigger layer 74 is located. The surge trigger layer 74 is located in the region directly under the metal film 64. Therefore, the surge current flows mainly in the region directly under the metal film 64; and the flow of the surge current outside the region directly under the metal film 64 can be suppressed. As a result, the concentration of the surge current at the periphery of the region directly under the end portion of the metal film 64 can be suppressed. The semiconductor device 2 is therefore more resistant to the surge current.

According to the embodiment, the shortest distance D1 between the outer edge of the surge trigger layer 74 and the outer edge of the metal film 64 when viewed along the Z-direction is not less than the shortest distance D2 between the cathode layer 71 and the anode layer 73 in the Z-direction. The concentration of the surge current in the region directly under the end portion of the metal film 64 can be more effectively suppressed thereby. Otherwise, the configuration, operations, and effects according to the embodiment are similar to those of the first embodiment.

The arrangement of the surge trigger layer 74 according to the embodiment is not limited to the example shown in FIG. 13B and may be, for example, any arrangement of the first to fourth modifications of the first embodiment or another arrangement. Although the first embodiment shows an example in which the semiconductor device is a MOSFET, and the second embodiment shows an example in which the semiconductor device is a JBS diode, the semiconductor device according to the invention is not limited thereto.

According to the embodiments described above, a semiconductor device that is highly resistant to the surge current can be realized.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

Embodiments include the following aspects.

### Note 1

A semiconductor device, comprising:
a first electrode;
a first semiconductor layer connected to the first electrode, the first semiconductor layer including silicon and carbon, the first semiconductor layer being of a first conductivity type;
a second semiconductor layer located on a portion of the first semiconductor layer, the second semiconductor layer contacting the first semiconductor layer and including silicon and carbon, the second semiconductor layer being of a second conductivity type;
a third semiconductor layer located on a first portion of the second semiconductor layer, the third semiconductor layer including silicon and carbon, the third semiconductor layer being of the first conductivity type;
a fourth semiconductor layer located on a second portion of the second semiconductor layer, the fourth semiconductor layer including silicon and carbon, the fourth semiconductor layer being of the second conductivity type, the fourth semiconductor layer having a higher carrier concentration than the second semiconductor layer;
a fifth semiconductor layer located on a third portion of the second semiconductor layer, the fifth semiconductor layer including silicon and carbon, the fifth semiconductor layer being of the second conductivity type, the fifth semiconductor layer having a higher carrier concentration than the second semiconductor layer, a length in a second direction of the fifth semiconductor layer being greater than a length in the second direction of the fourth semiconductor layer, the second direction crossing a first direction, the first direction being from the first electrode toward the first semiconductor layer;
a second electrode facing, via an insulating film, a portion of the second semiconductor layer located between the first semiconductor layer and the third semiconductor layer;
a third electrode connected to the third, fourth, and fifth semiconductor layers; and
a metal film connected to the third electrode, the metal film being located in a region that includes a region directly above the fifth semiconductor layer and is on the third electrode.

### Note 2

The device according to note 1, wherein
the first semiconductor layer includes:
   a first layer located on the first electrode; and
   a second layer located on the first layer, the second layer having a lower carrier concentration than the first layer, and
a shortest distance between an outer edge of the fifth semiconductor layer and an outer edge of the metal film when viewed along the first direction is not less than a shortest distance between the first layer and the second semiconductor layer in the first direction.

### Note 3

The device according to note 1 or 2, wherein
a plurality of the fifth semiconductor layers is provided, and
the plurality of fifth semiconductor layers is separated from each other.

### Note 4

The device according to note 3, wherein
the plurality of fifth semiconductor layers is arranged along the second direction.

### Note 5

The device according to note 4, wherein
the plurality of fifth semiconductor layers is arranged also along a third direction, and
the third direction crosses a plane parallel to the first and second directions.

### Note 6

The device according to note 3, wherein
the plurality of fifth semiconductor layers is arranged along a third direction, and
the third direction crosses a plane parallel to the first and second directions.

### Note 7

The device according to note 1 or 2, wherein
the fifth semiconductor layer includes:
   a portion extending in the second direction; and
   a portion extending along a third direction, and
the third direction crosses a plane parallel to the first and second directions.

### Note 8

The device according to note 1 or 2, further comprising:
a metal layer connected to the third electrode,
the metal layer being located between the third electrode and a portion of the first semiconductor layer above which the second semiconductor layer is not located,
the metal layer forming a Schottky junction with the first semiconductor layer.

### Note 9

A semiconductor device, comprising:
a first electrode;
a first semiconductor layer connected to the first electrode, the first semiconductor layer including silicon and carbon, the first semiconductor layer being of a first conductivity type;
a second semiconductor layer located on a portion of the first semiconductor layer, the second semiconductor layer contacting the first semiconductor layer and including silicon and carbon, the second semiconductor layer being of a second conductivity type;
a third semiconductor layer located on a portion of the second semiconductor layer, the third semiconductor layer contacting the second semiconductor layer and including silicon and carbon, the third semiconductor layer being of the second conductivity type, the third semiconductor layer having a higher carrier concentration than the second semiconductor layer;
a metal layer located on the first semiconductor layer, the metal layer forming a Schottky junction with the first semiconductor layer;
a second electrode located on the metal layer and connected to the metal layer; and
a metal film connected to the second electrode, the metal film being located in a region that is on the second electrode and includes a region directly above the third semiconductor layer.

### Note 10

The device according to note 9, wherein
the first semiconductor layer includes:
   a first layer located on the first electrode; and
   a second layer located on the first layer, the second layer having a lower carrier concentration than the first layer, and
a shortest distance between an outer edge of the third semiconductor layer and an outer edge of the metal film when viewed along the first direction is not less than a shortest distance between the first layer and the second semiconductor layer in the first direction.

### Note 11

The device according to note 9 or 10, wherein
the metal layer contacts the first, second, and third semiconductor layers.
It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A semiconductor device (1), comprising:
a first electrode (11);
a first semiconductor layer (21+22) connected to the first electrode, the first semiconductor layer including silicon and carbon, the first semiconductor layer being of a first conductivity type (n);
a second semiconductor layer (23) located on a portion of the first semiconductor layer, the second semiconductor layer contacting the first semiconductor layer and including silicon and carbon, the second semiconductor layer being of a second conductivity type (p);
a third semiconductor layer (24) located on a first portion of the second semiconductor layer, the third semiconductor layer including silicon and carbon, the third semiconductor layer being of the first conductivity type;
a fourth semiconductor layer (25) located on a second portion of the second semiconductor layer, the fourth semiconductor layer including silicon and carbon, the fourth semiconductor layer being of the second conductivity type, the fourth semiconductor layer having a higher carrier concentration than the second semiconductor layer;
a fifth semiconductor layer (26) located on a third portion of the second semiconductor layer, the fifth semiconductor layer including silicon and carbon, the fifth semiconductor layer being of the second conductivity type, the fifth semiconductor layer having a higher carrier concentration than the second semiconductor layer, a length in a second direction (Y) of the fifth semiconductor layer being greater than a length in the second direction of the fourth semiconductor layer, the second direction crossing a first direction (Z), the first direction being from the first electrode toward the first semiconductor layer;
a second electrode (13d) facing, via an insulating film (30), a portion (23c, 23d) of the second semiconductor layer (23) located between the first semiconductor layer and the third semiconductor layer;
a third electrode (12) connected to the third, fourth, and fifth semiconductor layers; and
a metal film (14) connected to the third electrode, the metal film being located in a region that includes a region directly above the fifth semiconductor layer and is on the third electrode.

2. The device according to claim 1, wherein
the first semiconductor layer (21+22) includes:
a first layer (21) located on the first electrode; and
a second layer (22) located on the first layer, the second layer having a lower carrier concentration than the first layer, and
a shortest distance (D1) between an outer edge of the fifth semiconductor layer and an outer edge of the metal film when viewed along the first direction is not less than a shortest distance (D2) between the first layer and the second semiconductor layer in the first direction.

3. The device according to claim 1 or 2, wherein
a plurality of the fifth semiconductor layers is provided, and
the plurality of fifth semiconductor layers is separated from each other.

4. The device according to claim 3, wherein
the plurality of fifth semiconductor layers is arranged along the second direction.

5. The device according to claim 4, wherein
the plurality of fifth semiconductor layers is arranged also along a third direction (X), and
the third direction crosses a plane parallel to the first and second directions.

6. The device according to claim 3, wherein
the plurality of fifth semiconductor layers is arranged along a third direction (X), and
the third direction crosses a plane parallel to the first and second directions.

7. The device according to claim 1 or 2, wherein
the fifth semiconductor layer (26) includes:
a portion (26b) extending in the second direction; and
a portion (26a) extending along a third direction, and
the third direction crosses a plane parallel to the first and second directions.

8. The device according to claim 1 or 2, further comprising:
a metal layer (28) connected to the third electrode,
the metal layer being located between the third electrode (12) and a portion (22b) of the first semiconductor layer (21+22) above which the second semiconductor layer (23) is not located,
the metal layer forming a Schottky junction with the first semiconductor layer.

9. A semiconductor device (2), comprising:
a first electrode (61);
a first semiconductor layer (71+72) connected to the first electrode, the first semiconductor layer including silicon and carbon, the first semiconductor layer being of a first conductivity type (n);
a second semiconductor layer (73) located on a portion of the first semiconductor layer, the second semiconductor layer contacting the first semiconductor layer and including silicon and carbon, the second semiconductor layer being of a second conductivity type (p);
a third semiconductor layer (74) located on a portion of the second semiconductor layer, the third semiconductor layer contacting the second semiconductor layer and including silicon and carbon, the third semiconductor layer being of the second conductivity type, the third semiconductor layer having a higher carrier concentration than the second semiconductor layer;
a metal layer (62) located on the first semiconductor layer, the metal layer forming a Schottky junction with the first semiconductor layer;
a second electrode (63) located on the metal layer and connected to the metal layer; and
a metal film (64) connected to the second electrode, the metal film being located in a region that is on the second electrode and includes a region directly above the third semiconductor layer.

10. The device according to claim 9, wherein
the first semiconductor layer (71+72) includes:
a first layer (71) located on the first electrode; and
a second layer (72) located on the first layer, the second layer having a lower carrier concentration than the first layer, and
a shortest distance (D1) between an outer edge of the third semiconductor layer and an outer edge of the metal film when viewed along the first direction is not less than a shortest distance (D2) between the first layer and the second semiconductor layer in the first direction.

11. The device according to claim 9 or 10, wherein
the metal layer contacts the first, second, and third semiconductor layers.
